# EUROPEAN PATENT APPLICATION

(11) **EP 4 535 656 A1**
(43) Date of publication of application: **09.04.2025**
(21) Application number: 23306726.3
(22) Date of filing: 06.10.2023
(51) Int. Cl.: H03B 17/00, H10N 30/30, G02F 1/365, H10N 30/87, G02F 1/21

(54) **OPTOMECHANICAL INTEGRATED MICROWAVE CLOCK**

(71) Applicant: Centre National de la Recherche Scientifique, 75016 Paris (FR); Université Paris Cité, 75006 Paris (FR); Université Paris-Saclay, 91190 Gif-sur-Yvette (FR)
(72) Inventor: BRAIVE, Rémy, 92120 MONTROUGE (FR); HORVATH, Robert, 91400 ORSAY (FR); MODICA, Giuseppe, 75011 PARIS (FR)
(74) Representative: IPAZ

(57) **Abstract**

The invention relates to an optomechanical microwave clock (100, 200, 300, 400) integrated on a chip (103), comprising:
- an optical waveguide (102) arranged on the chip (103),
- a nano-cavity (101) arranged substantially parallel to the optical waveguide (102),

wherein an optical mode excited in the nano-cavity (101) is modulated at an oscillation frequency of a mechanical mode of the nano-cavity (101), the modulated optical mode being evanescently coupled to the optical waveguide (102) in at least one coupling region;
wherein the optomechanical clock (100, 200, 300, 400) further comprises:
- mode-lock means configured to control the optomechanical oscillation stability of the optomechanical microwave clock.

## Description

### Field of the invention

The present invention relates to an optomechanical microwave clock integrated on a chip. In particular, the present invention relates to an optomechanical clock for an integrated photonic circuit.

The field of the invention is the field of optomechanical transducers, and more specifically the field of optomechanical transducers in the microwave domain.

### Background

Microwave oscillators have applications in various technical fields such as timekeeping protocols, precise positioning systems, sensors, or wireless telecommunications. Microwave photonics (MWP) bridges the gap between microwave electrical circuits and photonic components in the telecommunication band. MWP oscillators, where the clock signal is directly available in the optical domain for distribution, take advantage of the immunity to electromagnetic interference and low propagation losses of optical signals. Moreover, these techniques require low energy-consumption communication devices and benefit from the development of nanoscale integrated and transportable MWP oscillators. The most important requirements for these devices are the spectral purity of the generated microwave signals characterized by low phase noise and the long-term stability.

An example of MWP oscillators is an opto-electronic oscillator (OEO). These oscillators have high stability, but they are cumbersome due to several kilometres of optical fibers which also introduces a long enough time delay. On-chip integration is thus not possible.

Small-footprint oscillators based on electronics, on the other hand, such as crystal oscillators and voltage-controlled oscillators (VCO), meet on-chip integration criteria, but are by nature sensitive to electromagnetic interferences. Furthermore, their natural frequency lies in the MHz range and requires up-conversion for GHz applications. This up-conversion, in turn, comes at the cost of spectral purity.

Miniaturized and stable on-chip microwave photonic oscillators, working directly in the GHz and in a harsh electromagnetic environment, therefore remains a complicated task, especially for applications in satellite communications and 5G networks.

In this context, a new generation of oscillators based on optomechanics have become of interest as candidates to overcome the current limitations of OEOs. Their working principle is the following: by simultaneously confining an optical mode at telecommunication wavelengths and a mechanical mode, optomechanical oscillators (OMO) directly imprint GHz oscillations on the optical carrier. Among the numerous optomechanical systems, semiconductor optomechanical crystals in 2D or 1D with their natural compactness are among the best systems for nanoscale integration of such oscillators. In the GHz frequency range, demonstrations of Brownian motion in one dimensional optomechanical crystals has already been reported on numerous platforms, such as silicon-based materials, e.g. Si, SiN, or III-V semiconductors such as GaAs, InGaP, or Lithium Niobate (LN).

Compared to silicon, III-V semiconductors can exhibit larger electron bandgap and piezoelectric properties. These properties are leading to low two-photon absorption, therefore to efficient devices in the telecom wavelength range. Piezoelectricity allows for direct on-chip electromechanical control of OMOs.

However, even if such OMOs benefit from good integrability, they do not exhibit the spectral purity and long-term stability as required.

### Summary of the invention

A purpose of the present invention is to overcome at least one of the drawbacks of the known techniques.

A purpose of the present invention is to propose an optomechanical clock having stable optical and mechanical frequencies.

Another purpose of the invention is to propose a transportable optomechanical clock, having compact dimensions allowing its integration in mobile systems, such as telecommunication systems.

At least one of these aims is achieved by an optomechanical microwave clock integrated on a chip, comprising:
- an optical waveguide arranged on the chip,
- a nano-cavity arranged substantially parallel to the optical waveguide,

wherein an optical mode excited in the nano-cavity is modulated at an oscillation frequency of a mechanical mode of the nano-cavity, the modulated optical mode being evanescently coupled to the optical waveguide in at least one coupling region;
wherein the optomechanical clock further comprises:
   - mode-lock means configured to control the optomechanical oscillation stability of the optomechanical microwave clock.

The optomechanical clock according to the present invention represents an optomechanical oscillator integrated on a chip, which can be integrated with photonic circuits.

The optomechanical clock according to the invention may be excited by injecting an optical signal with an adapted wavelength in the optical waveguide which then excites an optical mode and a mechanical mode in the nano-cavity.

The modulation frequency, i.e., the frequency of the clock, is in the GHz range.

The optical waveguide may be provided with optical gratings at its ends, by means of which the optical signal may be coupled from an optical fiber into the waveguide and vice versa.

In the present invention, a heterogeneously integrated optomechanical oscillator on semiconductor circuitry is proposed which combines the properties of the oscillator's material and the advantages of the platform in terms of cost, manufacturability and integrability. The optomechanical oscillator with the integrated mode-lock means allows for improving the stability of the modulation of the optical signal, by stabilizing either one or both of the optical and the mechanical mode of the nano-cavity. Indeed, the phase noise of the oscillation of the nano-cavity is significantly decreased. Sub-Hz linewidth oscillations may be achieved. Together with its on-chip integration, the optomechanical clock according to the present invention represents a serious contender for oscillator applications.

The optomechanical oscillator may comprise a pair of electrodes configured to produce an electrical field through the nano-cavity. An electrode is arranged on-chip on either of the longitudinal sides of the nano-cavity.

According to an embodiment, the mode-lock means may comprise a radio-frequency electric excitation means oscillating at the frequency of the mechanical mode of the nano-cavity.

The RF electric excitation means may comprise a radio-frequency LC circuit.

The LC circuit allows for a resonant radio-frequency injection in the nano-cavity. This can be realized, for example, by means of two electrodes placed on either of the longitudinal sides of the nano-cavity and placed at a distance of the same. The electrodes establish an electrical field that is adapted to displace the nano-cavity in the direction perpendicular to the direction of the optical mode.

An RF LC circuit allows for enhanced stability of the mechanical mode, within a small package size.

According to an embodiment, the mode-lock means may comprise a radio-frequency acoustic excitation means oscillating at the frequency of the mechanical mode of the nano-cavity.

According to an embodiment, the radio-frequency acoustic excitation means may comprise an acoustic passive loop.

The acoustic passive loop may comprise an acoustic waveguide. The acoustic waveguide is preferably an on-chip acoustic waveguide.

In that case, the acoustic excitation may be coupled to the acoustic passive loop by means of an additional acoustic waveguide, preferably an additional on-chip acoustic waveguide.

According to an embodiment, the mode-lock means may comprise an optical frequency-comb generator.

An optical frequency-comb generator allows for locking the optical mode of the nano-cavity to the frequency-comb generator's mode. This allows for enhanced stability of the optical mode.

The optical frequency-comb generator is preferably an on-chip generator.

Preferably, the optical waveguide of the optomechanical clock is a silicon waveguide.

Silicon is particularly suitable for guiding optical signals with wavelengths in the telecommunications range.

Preferably, the optomechanical clock according to the invention may be implemented on a silicon-on-insulator (SoI) platform, i.e., the chip on which the optomechanical microwave clock is integrated comprises a silicon-on-insulator substrate. In particular, the nano-cavity may be fabricated on top of a commercial SoI photonic circuit, containing predefined silicon waveguides. preceding claims, characterized in that.

Silicon-on-insulator platforms or substrates provide advantages in terms of integrability and convenient manufacturability.

Alternatively, the optical waveguide of the optomechanical clock may also be of silicon nitride (SiN), or of any other suitable semiconductor material.

According to an embodiment, the nano-cavity may be suspended in the air parallel above the optical waveguide by means of anchoring means.

The anchoring means may be positioned at the two ends of the nanocavity to control the optical coupling between the optical waveguide and the nano-cavity.

The nano-cavity may also be referred to as a nanobeam because of its appearance, or photonic wire.

According to a preferred embodiment, the nano-cavity comprises a photonic crystal.

The photonic crystal may be, for example, a gallium phosphide (GaP) photonic crystal.

GaP, as a III-V semiconductor, has attractive properties for optomechanics. GaP is a suitable choice because of its advantageous physical properties for both optics and acoustics. This material has a large band gap and thus weak two-photon absorption. It also presents a piezoelectric coefficient, allowing for efficient acoustic actuation.

This material is a promising choice for emerging quantum technologies.

The integration of a GaP photonic crystal nano-cavity on the well-established technology of silicon photonics is also a strong requirement for on-chip systems, in terms of manufacturability, transportability, and integrability. Such integrated systems should also be less sensitive to environment disturbances.

The photonic crystal may also be, for example, a gallium arsenide (GaAs) or an indium phosphide (InP) crystal, or any other III-V semiconductor compound.

The photonic crystal may alternatively be made of lithium niobate (LiNbO₃), aluminium gallium nitride compounds (AlₓGa₁₋ₓN), or indium gallium phosphide compounds (InₓGa₁₋ₓP).

According to alternative embodiments, the nano-cavity may comprise a micro-disc, or any other means adapted to confine simultaneously an optical and an acoustic mode.

### Description of the figures and embodiments

Other advantages and characteristics will become apparent on examination of the detailed description of an embodiment which is in no way limitative, and the attached figures, where:
- FIGURE 1 shows diagrammatic representations of an embodiment of an integrated optomechanical microwave clock according to the invention;
- FIGURE 2 shows an electrical spectrum of an optomechanical clock according to an embodiment of the invention;
- FIGURE 3 shows a diagrammatic representation of an embodiment of an integrated optomechanical microwave clock according to the invention;
- FIGURE 4 shows a diagrammatic representation of another embodiment of an integrated optomechanical microwave clock according to the invention; and
- FIGURE 5 shows a diagrammatic representation of yet another embodiment of an integrated optomechanical microwave clock according to the invention.

It is well understood that the embodiments that will be described below are in no way limitative. In particular, it is possible to imagine variants of the invention comprising only a selection of the characteristics described hereinafter, in isolation from the other characteristics described, if this selection of characteristics is sufficient to confer a technical advantage or to differentiate the invention with respect to the state of the prior art. Such a selection comprises at least one, preferably functional, characteristic without structural details, or with only a part of the structural details if this part alone is sufficient to confer a technical advantage or to differentiate the invention with respect to the prior art.

In the Figures, elements common to several Figures may keep the same reference.

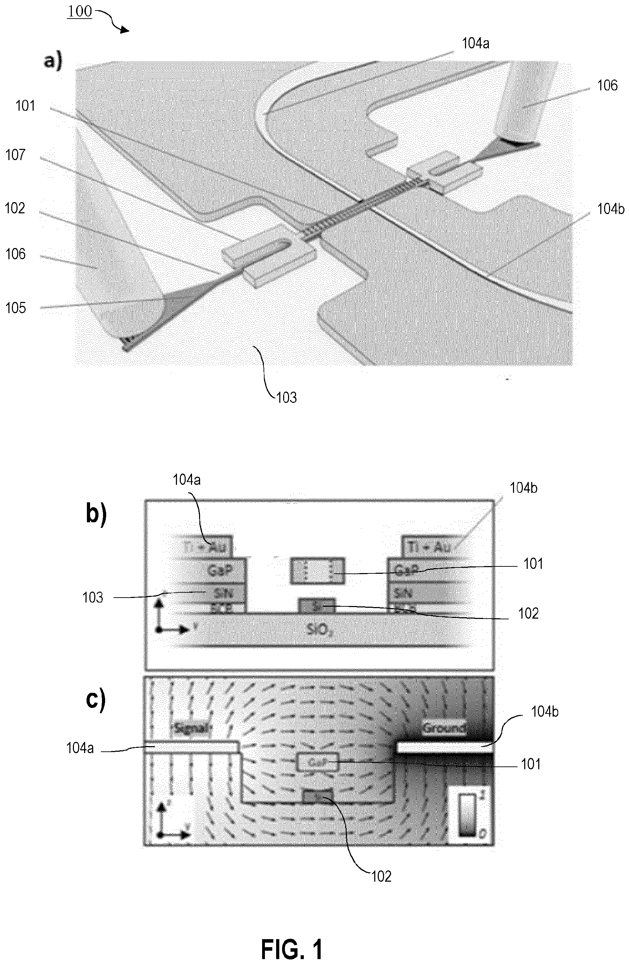

Figure 1 is a diagrammatic representation of an embodiment of an integrated optomechanical microwave clock according to the invention. The optomechanical clock 100 comprises an optical waveguide 102 arranged on a chip 103, or semiconductor platform. The optomechanical clock 100 also comprises a nano-cavity 101 arranged substantially parallel to the optical waveguide 102.

In the embodiment as illustrated in Figure 1, the nano-cavity 101 comprises a GaP optomechanical crystal. The nano-cavity 101 is referred to as a nanobeam. It is fabricated on top of a Silicon-on-Insulator (SoI) photonics circuit. The optomechanical clock 100 also comprises a pair of electrodes 104a, 104b. One electrode 104a, 104b is arranged on either of the longitudinal sides of the nanobeam 101, at a distance to the nanobeam 101.

This SoI platform comprises at least one silicon (Si) waveguide 102. In particular, the platform may comprise several pre-defined silicon waveguides. The at least one waveguide 102 has optical gratings 105 at each end, allowing for the coupling of optical signal from and to optical fibers 106.

Figure 1a) shows a schematic view of the optomechanical clock 100 with optical fibers 106 positioned above the waveguide gratings 105.

Figure 1b) is a cross-sectional view of the optomechanical clock 100 showing its different layers as well as the position of the electrodes 104a, 104b close to the nanobeam 101.

The nanobeam 101 is preferably made of a III-V semiconductor material, such as GaP, GaAs, InP, or InₓGa₁₋ₓP.

Through their parallel arrangement, reproducible and efficient evanescent coupling between the Si waveguide 102 and the III-V cavity 101 may be achieved.

The nanobeam 101 is suspended in the air, parallel with respect to the Si waveguide 102, by means of two anchors 107 located at the respective ends of the nanobeam 101. With reference to Figure 1b), a SiN layer 109 below the GaP layer keeps the GaP layer (of which the nanobeam 101 is made) raised so as not to touch the Si waveguide 102. Once the GaP layer has been dry-etched, the SiN layer is removed under the nanobeam 101. The nanobeam 101 is thus suspended while the anchors 107 remain set on the SiN layer.

The electric field between the electrodes 104a, 104b may be used to actuate the nanobeam 101. The simulated electric field is illustrated in Figure 1d) with arrows, and the electric potential with a grey scale.

Preferably, the nano-cavity 101 is a photonic crystal (PhC) cavity. It is specifically designed for optical and mechanical modes to overlap, resulting in high optomechanical coupling rates. Geometric design parameters are the height of elliptical holes and the adjacent-hole distance of the crystal. In an example, both are increasing by following a Gaussian distribution with each step from the cavity centre to the mirror section at the ends of the nanobeam 101. These end sections are composed of identical and equally spaced holes that act as a mirror for the targeted optical and mechanical frequencies. This co-design results in a good confinement of both the optical modes and the GHz mechanical modes in the nano-cavity 101.

The mechanical motion of the nanobeam 101 modulates the light coupled to the nano-cavity 101 and this modulation gets imprinted on the light exiting the nano-cavity 101 into the waveguide 102. The output optical signal may then be read with a photodiode and an electrical spectrum analyzer.

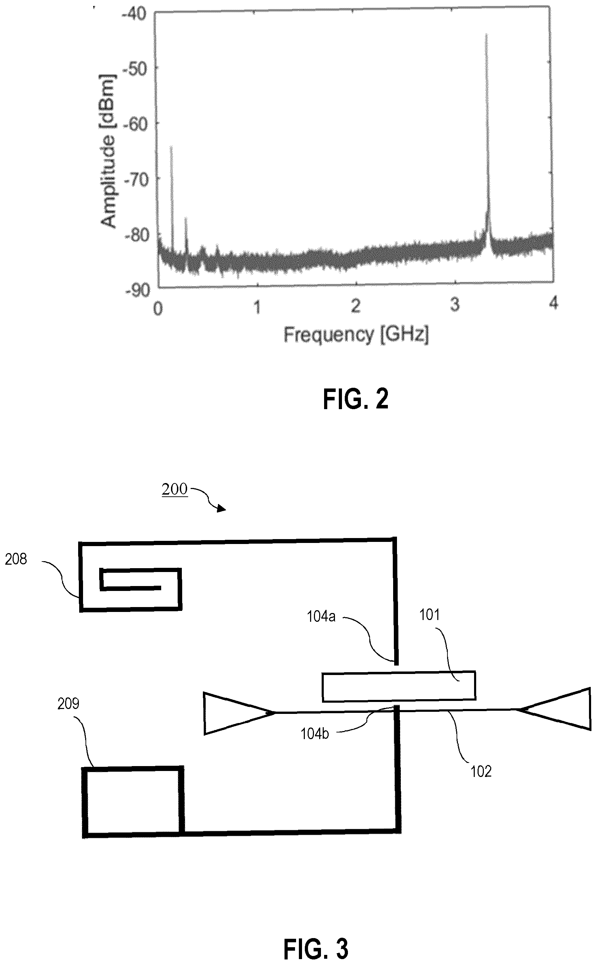

A typical electrical spectrum in the 0-4 GHz range is shown on Figure 2. The peaks up to 500 MHz on the recorded spectrum correspond to mechanical modes not confined in the nano-cavity, with displacement fields along the full length of the photonic wire, or nanobeam. The peak at 3.35 GHz, on the other hand, corresponds to a localized mechanical mode.

The nanobeam may be mechanical excited using different excitation means.

According to a first example, a mechanical mode in the nano-cavity may be excited by injecting a single-mode laser in the nanobeam through the Si waveguide around the resonance wavelength. This leads to the excitation of the mechanical eigenmodes of the PhC.

An important figure of merit of the spectral purity of the mechanical mode is the phase noise, which gives information on the linewidth and the short-term stability of the oscillation. The phase noise depends on the wavelength detuning from the resonance and the optical powers injected.

According to a second example, a mechanical mode in the nano-cavity may be excited by actuating the on-chip electrodes. This electro-mechanical actuation of the nanobeam can be achieved because of the piezoelectric properties of GaP. Thus, in order to optimize electro-mechanical coupling without disturbing the optical field, the nanobeam is placed between the two electrodes, aligned with respect to the centre of the nano-cavity. The electrodes may be, for example, 1 µm wide gold electrodes. The electrode-to-nanobeam side distance may be 1 µm. When a potential is applied at the electrodes, they create a transverse electric field across the nanobeam. Actuation efficiency can be optimized with a field oriented along the longitudinal direction of the nanobeam; however, this configuration would need a complicated fabrication process.

Applying a periodic signal on the electrodes while coupling laser light close to the resonance of the nanobeam allows observing the electro-mechanical actuation transduced into the optical domain. When the driving frequency is close to the self-sustained oscillation of the nanobeam, the self-sustained oscillation locks on the signal generator, wherein a higher injected electrical power induces a wider locking range.

The optomechanical clock according to the present invention further comprises mode-lock means. These mode-lock means allow for locking either or both of the optical and mechanical modes of the nano-cavity. Embodiments of mode-lock means are described in the following with reference to Figures 3 to 5.

Figure 3 is a diagrammatic representation of an embodiment of an optomechanical clock 200 according to the present invention. In this embodiment, the mode-lock means comprise a radio-frequency resonant LC circuit. This RF LC circuit constitutes an electrical excitation means, generating a frequency corresponding to the frequency of the mechanical mode of the nano-cavity 201.

The RF LC circuit comprises an integrated inductance 208 and capacitor 209 allowing for an electronic resonance at the same frequency as the mechanical mode frequency. The circuit is coupled to the nanobeam 101 by a pair of electrodes 104a, 104b, for example such as the ones illustrated in Figure 1a). The inductance 208 may be formed by a spiral of metal wire, for example the same metal as the one used for the electrodes 104a, 104b. The capacitor 209 may be implemented by metallic interdigitated electrodes.

As mentioned above, the piezoelectric coefficient of the material used for the nanobeam 101 allows a mechanical displacement induced by an electrical excitation. To efficiently excite and enhance the mechanical displacement at the mechanical frequency of the mode (e.g., 3.4 GHz), an electrical resonance at the exact same frequency is mandatory. The dimensions and the metal used for the RF LC circuit allow to adjust the RF frequency close to the one of the nanobeam 101. This resonant effect improves the efficiency of the mode-lock means.

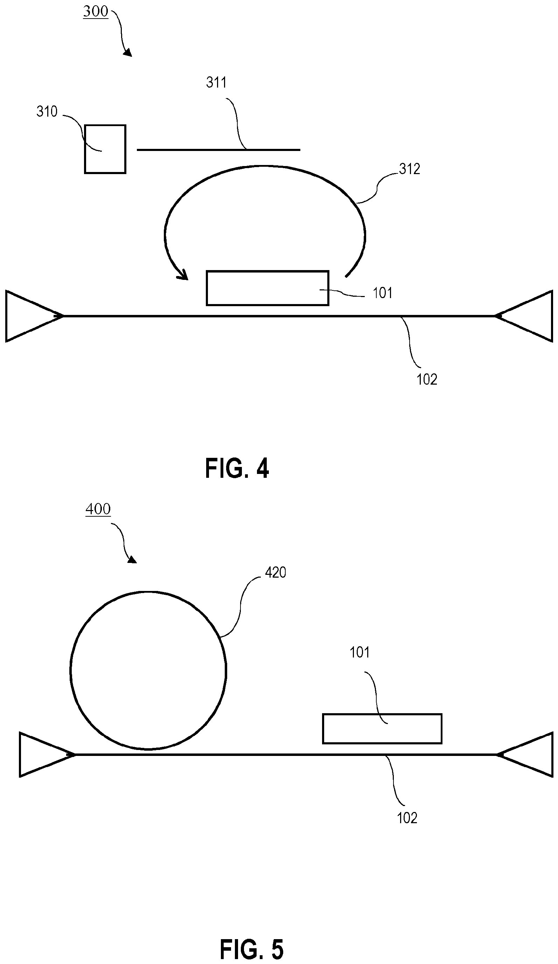

Figure 4 is a diagrammatic representation of another embodiment of an optomechanical clock 300 according to the present invention. In this embodiment, the mode-lock means comprise radio-frequency acoustic excitation means, and in particular an RF acoustic generator 310. The RF acoustic generator 310 realizes an electromechanical excitation in a distance from the nanobeam 101. The acoustic generator may be implemented by an on-chip interdigitated electrode with a sub-micron spacing which controls the RF frequency. The spacing has to be adjusted in order to have a frequency matching with the frequency of the mechanical mode of the nanobeam101.

The RF generator 310 is coupled to an acoustic waveguide 311, preferably an on-chip acoustic waveguide. As represented in Figure 4, the mode-lock means comprise also an acoustic passive loop 312 to which the acoustic waveguide 311 is coupled. The acoustic passive loop 312 may comprise an additional acoustic waveguide, which also is preferably an on-chip acoustic waveguide.

Thanks to the piezoelectric electric coefficient of the material, the interdigitated electrode 310 generates an acoustic wave at the frequency of the nanobeam 101. The frequency is adjusted with the geometrical parameters of the RF generator 310 and the material used. The acoustic waveguide 311 is used to collect the acoustical energy going out of the interdigitated electrode 310 and to route it towards the acoustic passive loop 312. The acoustic confinement is done by engineering the acoustic dispersion in and perpendicularly to the propagating direction of the acoustical wave. The control of the coupling between the acoustic waveguide 311 and the acoustic passive loop 312 can be realized by the relative distance between them. The frequency of the optomechanical clock is injection-locked by the acoustic wave with a delay induced by the passive loop 312.

Figure 5 is a diagrammatic representation of another embodiment of an optomechanical clock 400 according to the present invention. In this embodiment, the mode-lock means comprise an optical frequency-comb generator 420. This generator 420 is an optical micrometer-size resonator made of a material with nonlinear properties. To overcome the material dispersion, group-velocity dispersion has to be engineered by adjusting the geometrical parameters of the micrometer-size resonator.

The optical frequency-comb generator 420 is optically coupled to the same optical waveguide 102 as the nanobeam 101. The injected laser light generates an optical frequency comb of which one of the lines addresses the resonance of nanobeam 101. By adjusting the power and the wavelength of the injected laser light, the spacing and stability of the frequency comb can be adjusted. The resonance of the nanobeam 101 will be locked to the stabilized light line, improving the overall phase-noise performances of the optomechanical clock 400.

The mode-lock means according to the embodiments detailed with respect to Figures 3 to 5 may be combined with each other in an optomechanical clock.

Of course, the invention is not limited to the examples detailed above.

## Claims

1. An optomechanical microwave clock (100, 200, 300, 400) integrated on a chip (103), comprising:
- an optical waveguide (102) arranged on the chip (103),
- a nano-cavity (101) arranged substantially parallel to the optical waveguide (102),
wherein an optical mode excited in the nano-cavity (101) is modulated at an oscillation frequency of a mechanical mode of the nano-cavity (101), the modulated optical mode being evanescently coupled to the optical waveguide (102) in at least one coupling region;
wherein the optomechanical clock (100, 200, 300, 400) further comprises:
- mode-lock means configured to control the optomechanical oscillation stability of the optomechanical microwave clock.

2. The optomechanical clock (100, 200, 300, 400) according to claim 1, **characterized in that** it further comprises a pair of electrodes (104a, 104b) configured to produce an electrical field through the nano-cavity (101), wherein one electrode (104a, 104b) is arranged on-chip on either of the longitudinal sides of the nano-cavity (101).

3. The optomechanical clock (100, 200, 300, 400) according to claim 1 or 2, **characterized in that** the mode-lock means comprise a radio-frequency electric excitation means oscillating at the frequency of the mechanical mode of the nano-cavity.

4. The optomechanical clock (200) according to any one of the preceding claims, **characterized in that** the radio-frequency electric excitation means comprise a radio-frequency LC circuit (208, 209).

5. The optomechanical clock (300) according to any one of the preceding claims, **characterized in that** the mode-lock-means comprises radio-frequency acoustic excitation means (310, 311, 312) oscillating at the frequency of the mechanical mode of the nano-cavity (101).

6. The optomechanical clock (300) according to the preceding claim, **characterized in that** the radio-frequency acoustic excitation means comprises an acoustic passive loop (312).

7. The optomechanical clock (300) according to the preceding claim, **characterized in that** the acoustic passive loop (312) comprises an acoustic waveguide.

8. The optomechanical clock (400) according to any one of the preceding claims, **characterized in that** the mode-lock-means comprises an optical frequency-comb generator (420).

9. The optomechanical clock (100, 200, 300, 400) according to any of the preceding claims, **characterized in that** the optical waveguide (102) is a silicon waveguide.

10. The optomechanical clock (100, 200, 300, 400) according to any of the preceding claims, wherein the nano-cavity (101) is suspended in the air parallel above the optical waveguide (102) by means of anchoring means (107).

11. The optomechanical clock (100, 200, 300, 400) according to any of the preceding claims, wherein the nano-cavity (101) comprises a photonic crystal.

12. The optomechanical clock (100, 200, 300, 400) according to the preceding claim, **characterized in that** the photonic crystal is a GaP photonic crystal.

13. The optomechanical clock (100, 200, 300, 400) according to any of the preceding claims, **characterized in that** the chip (103) comprises a silicon-on-insulator substrate.
